# EUROPEAN PATENT SPECIFICATION

(11) **EP 2 399 270 B1**
(45) Date of publication and mention of the grant of the patent: **12.06.2013**
(21) Application number: 10704819.1
(22) Date of filing: 17.02.2010
(51) Int. Cl.: H01J 37/16, H01J 37/18, H01J 37/20, H01J 37/305, H01J 37/317

(54) **CHARGED PARTICLE LITHOGRAPHY APPARATUS**
LITHOGRAFIEVORRICHTUNG MIT GELADENEM TEILCHEN
APPAREIL DE LITHOGRAPHIE À PARTICULES CHARGÉES

(30) Priority: 22.02.2009 US 154415 P
(43) Date of publication of application: 28.12.2011
(73) Proprietor: Mapper Lithography IP B.V., 2628 XK Delft (NL)
(72) Inventor: DE BOER, Guido, NL-4145 LN Leerdam (NL); BALTUSSEN, Sander, NL-4824 GB Breda (NL); JAGER, Remco, NL-3038 CW Rotterdam (NL); PEIJSTER, Jerry, Johannes, Martinus, NL-3738 VS Maartensdijk (NL); TEEPEN, Tijs, Frans, NL-5032 EW Tilburg (NL); VAN NIEUWSTADT, Joris, Anne, Henri, NL-3581 NT Utrecht (NL); WEEDA, Willem, Maurits, NL-3071 KL Rotterdam (NL); VAN VEEN, Alexander, Hendrik, Vincent, NL-3039 ER Rotterdam (NL)
(74) Representative: Mooij, Maarten
(86) International application number: PCT/EP2010/052004
(87) International publication number: WO 2010/094719

(56) References cited:
- JP-A- 2008 129 358
- US-A- 4 695 732
- US-A- 5 677 109
- US-A1- 2003 155 534
- US-A1- 2004 263 819
- US-A1- 2005 001 178
- US-A1- 2007 278 418
- US-B2- 7 372 027

## Description

### BACKGROUND OF THE INVENTION

### 1. Field of the Invention

The present invention relates to a charged particle lithography apparatus. The invention further relates to an arrangement of such a lithography apparatus and a frame for supporting a vacuum chamber.

### 2. Description of the Related Art

Charged particle and optical lithography machines and inspection machines are typically operated in a vacuum environment. This requires a vacuum chamber large enough to house the lithography machine or group of machines. The vacuum chamber must be sufficiently strong and airtight to support the required vacuum, while having openings for electrical, optical and power cabling to enter the chamber, for the wafer or target to be loaded into the chamber, and to permit access to machine for maintenance and operational needs. Where charged particle machines are involved, the vacuum chamber must also provide shielding to prevent external electromagnetic fields from interfering with the operation of the machine.

Prior vacuum chamber designs have suffered from various drawbacks such as excessive weight relative to throughput of the lithography machine, excessive use of floor space, absence of a door, and poor electromagnetic shielding around the openings.

### BRIEF SUMMARY OF THE INVENTION

The present invention aims to provide an improved vacuum chamber addressing the shortcomings of prior designs. According to one aspect of the invention, a charged particle lithography apparatus is provided according to claim 1.

According to a further aspect of the invention, in the apparatus, one or more subsystems of the apparatus are constructed in self-contained and removable modules. The removable modules comprise one or more of:
- an illumination optics module including a charged particle beam source and beam collimating system;
- an aperture array and condenser lens module including an aperture array and condenser lens array;
- a beam switching module including a beamlet blanker array; and
- a projection optics module including a beam stop array, beam deflector array, and one or more projection lens arrays.

According to another aspect of the invention, an arrangement comprises a charged particle lithography apparatus according as mentioned above and a frame for supporting the vacuum chamber of the charged particle lithography apparatus. The vacuum chamber and the frame are coupled to each other via a vibration damping element.

### BRIEF DESCRIPTION OF THE DRAWINGS

Various aspects of the invention will be further explained with reference to embodiments shown in the drawings wherein:

FIG. 1 is a simplified schematic drawing of an embodiment of a charged particle lithography system;

FIG. 2 is a cross section view showing an embodiment of a charged particle source environment in a vacuum chamber;

FIG. 3 is a simplified block diagram of a modular lithography system;

FIG. 4A is a perspective view of a vacuum chamber for a charged particle lithography system;

FIG. 4B is a side view of the vacuum chamber of FIG. 4A;

FIG. 4C is a front view of the vacuum chamber of FIG. 4A;

FIG. 4D is a cross section view of a portion of the vacuum chamber of FIG. 4A;

FIG. 5A is a perspective drawing of a section of a vacuum chamber wall having mu metal layers;

FIG. 5B is a perspective drawing of a section of a vacuum chamber wall having a composite structure with a honeycomb layer;

FIG. 6A is a cross section view through a bottom wall of a vacuum chamber showing the interface with a frame supporting member;

FIG. 6B is a cross section view showing an alternative interface with a frame supporting member;

FIG. 6C is a cross section view showing another alternative interface with a frame supporting member;

FIG. 7A is a rear perspective view of an alternative embodiment of a vacuum chamber;

FIG. 7B is a front perspective view of the vacuum chamber of FIG. 7A; and

FIG. 7C is a detail view of the vacuum chamber of FIG. 7A.

### DESCRIPTION OF ILLUSTRATIVE EMBODIMENTS

The following is a description of various embodiments of the invention, given by way of example only and with reference to the drawings.

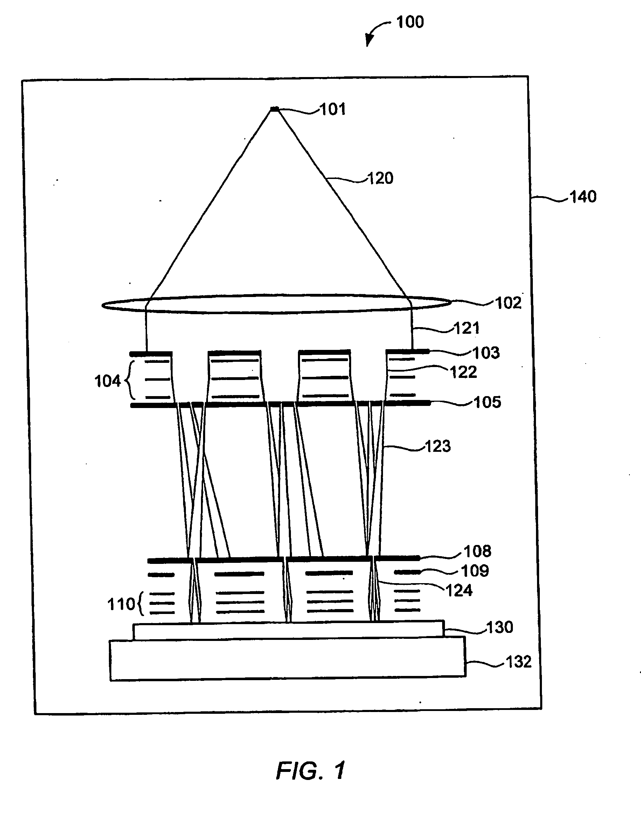

FIG. 1 shows a simplified schematic drawing of an embodiment of a charged particle lithography system 100. Such lithography systems are described for example in U.S. Patent Nos. 6,897,458 and 6,958,804 and 7,019,908 and 7,084,414 and 7,129,502, U.S. patent application publication no. 2007/0064213, and co-pending U.S. patent applications Serial Nos. 61/031,573 and 61/031,594 and 61/045,243 and 61/055,839 and 61/058,596 and 61/101,682, which are all assigned to the owner of the present invention. In the embodiment shown in FIG. 1, the lithography system comprises an electron source 101 for producing an expanding electron beam 120. The expanding electron beam 20 is collimated by collimator lens system 102. The collimated electron beam 121 impinges on an aperture array 103, which blocks part of the beam to create a plurality of beamlets 122. The system generates a large number of beamlets 122, preferably about 10,000 to 1,000,000 beamlets.

The electron beamlets 122 pass through a condenser lens array 104 which focuses the electron beamlets 122 in the plane of a beam blanker array 105, comprising a plurality of blankers for deflecting one or more of the electron beamlets. The deflected and undeflected electron beamlets 123 arrive at beam stop array 108, which has a plurality of apertures. The beamlet blanker array 105 and beam stop array 108 operate together to block or let pass the beamlets 123. If beamlet blanker array 105 deflects a beamlet, it will not pass through the corresponding aperture in beam stop array 108, but instead will be blocked. But if beamlet blanker array 105 does not deflect a beamlet, then it will pass through the corresponding aperture in beam stop array 108, and through beam deflector array 109 and projection lens arrays 110.

Beam deflector array 109 provides for deflection of each beamlet 124 in the X and/or Y direction, substantially perpendicular to the direction of the undeflected beamlets, to scan the beamlets across the surface of target 130. Next, the beamlets 124 pass through projection lens arrays 110 and are projected onto target 130. The projection lens arrangement preferably provides a demagnification of about 100 to 500 times. The beamlets 124 impinge on the surface of target 130 positioned on moveable stage 132 for carrying the target. For lithography applications, the target usually comprises a wafer provided with a charged-particle sensitive layer or resist layer.

The charged particle lithography system operates in a vacuum environment. A vacuum is desired to remove particles which may be ionized by the charged particle beams and become attracted to the source, may dissociate and be deposited onto the machine components, and may disperse the charged particle beams. A vacuum of at least 10⁻⁶ Bar is typically required. In order to maintain the vacuum environment, the charged particle lithography system is located in a vacuum chamber 140. All of the major elements of the lithography system are preferably housed in a common vacuum chamber, including the charged particle source, projector system for projecting the beamlets onto the wafer, and the moveable wafer stage.

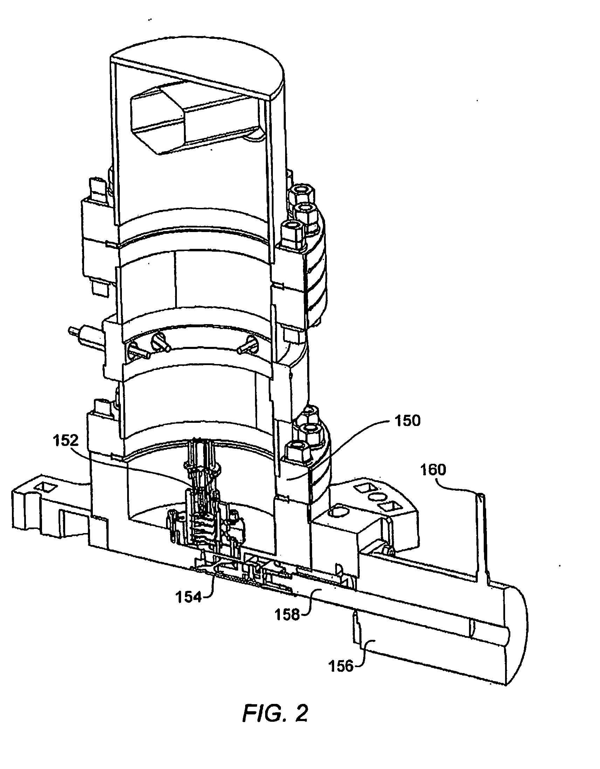

In an embodiment the charged particle source environment is differentially pumped to a considerably higher vacuum of up to 10⁻¹⁰ mbar. FIG. 2 is a cross section view showing an embodiment of a charged particle source environment in a vacuum chamber. In this embodiment, a considerably higher vacuum of up to 10⁻¹⁰ mbar may be obtained by differential pumping.

The differential pumping can be obtained by the inclusion in the vacuum chamber of a local source chamber 150 for the source 152. Although only a single source 152 is shown in FIG. 2, it must be understood that the source chamber 150 may comprise more sources. The high vacuum within the source chamber 150 may promote the life time of the source 152, and for some sources 152 may even be required for their functioning.

In the embodiment shown in FIG. 2, the source chamber 150 is provided with a valve 154 for closing a connection between the source chamber 150 and the vacuum chamber if needed, that is if the pressure level within the source chamber 150 needs to be maintained at a much lower pressure level than the pressure level in the vacuum chamber.

The valve 154 is controlled by an actuation unit 156 that controls movement of a bar 158 that is coupled to the valve 154.

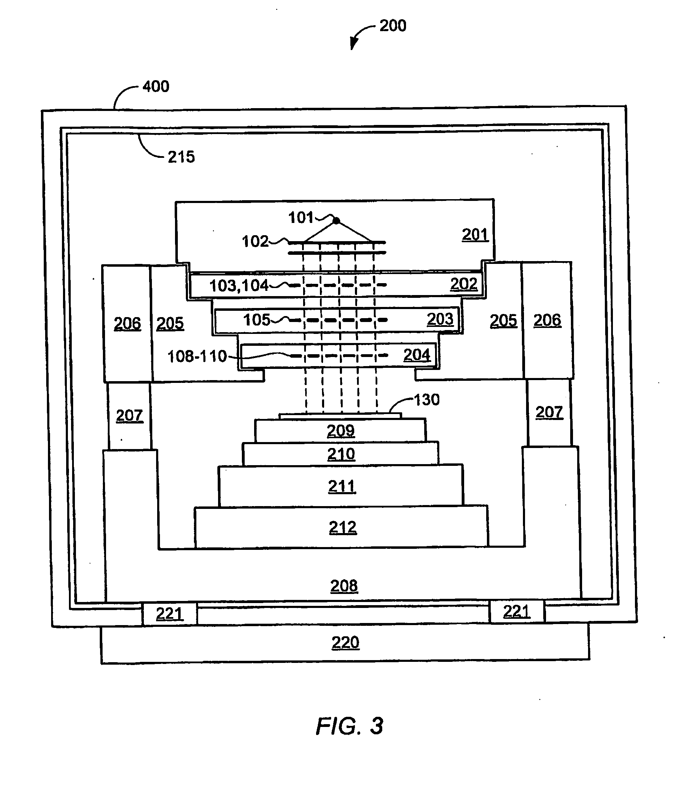

FIG. 3 shows a simplified block diagram illustrating the principal elements of a modular lithography system. The lithography system is preferably designed in a modular fashion to permit ease of maintenance. Major subsystems are preferably constructed in self-contained and removable modules, so that they can be removed from the lithography machine with as little disturbance to other subsystems as possible. This is particularly advantageous for a lithography machine enclosed in a vacuum chamber, where access to the machine is limited. Thus, a faulty subsystem can be removed and replaced quickly, without unnecessarily disconnecting or disturbing other systems.

In the embodiment shown in FIG. 3, these modular subsystems include an illumination optics module 201 including the charged particle beam source 101 and beam collimating system 102, an aperture array and condenser lens module 202 including aperture array 103 and condenser lens array 104, a beam switching module 203 including beamlet blanker array 105, and projection optics module 204 including beam stop array 108, beam deflector array 109, and projection lens arrays 110. The modules are designed to slide in and out from an alignment frame. In the embodiment shown in FIG. 3, the alignment frame comprises an alignment inner subframe 205 and an alignment outer subframe 206. A frame 208 supports the alignment subframes 205 and 206 via vibration damping mounts 207. The wafer 130 rests on wafer table 209, which is in turn mounted on chuck 210. Chuck 210 sits on the stage short stroke 211 and long stroke 212. The lithography machine is enclosed in vacuum chamber 400, which includes a mu metal shielding layer or layers 215. The machine rests on base plate 220 supported by frame members 221.

Each module requires a large number of electrical signals and/or optical signals, and electrical power for its operation. The modules inside the vacuum chamber receive these signals from control systems which are typically located outside of the chamber. The vacuum chamber includes openings, referred to as ports, for admitting cables carrying the signals from the control systems into the vacuum housing while maintaining a vacuum seal around the cables. Each module preferably has its collection of electrical, optical, and/or power cabling connections routed through one or more ports dedicated to that module. This enables the cables for a particular module to be disconnected, removed, and replaced without disturbing cables for any of the other modules. In some embodiments, a patch panel may be provided within the vacuum chamber. The patch panel comprises one or more connectors for removably connecting one or more connections of the modules. One or more ports may be used for admitting the one or more connections of the removable modules into the vacuum chamber.

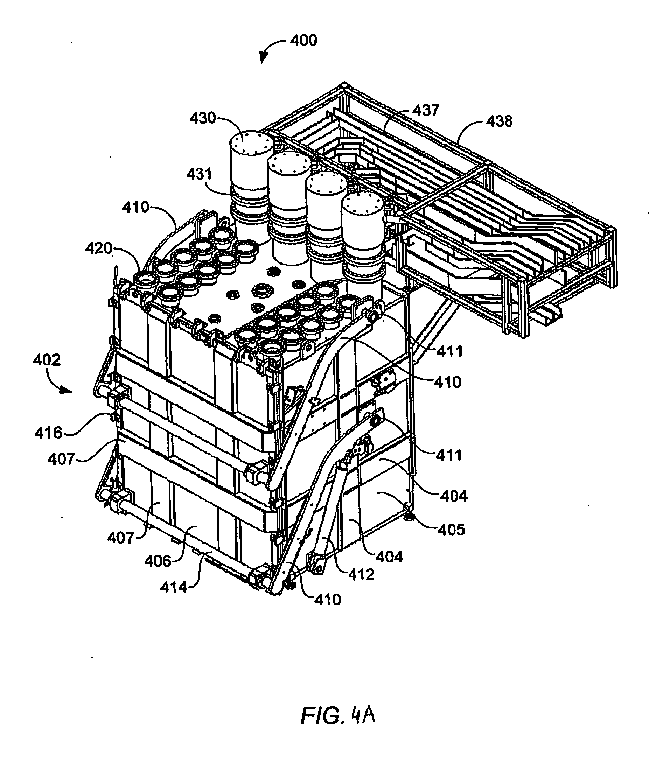

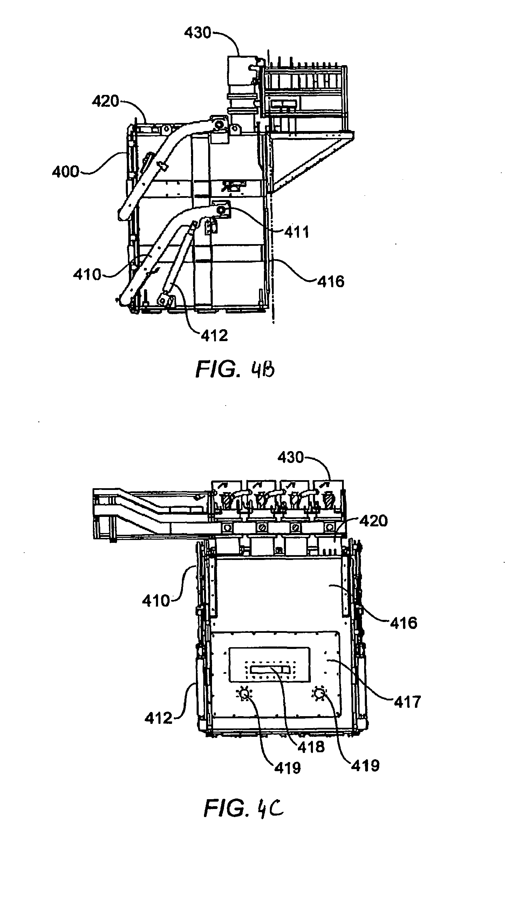

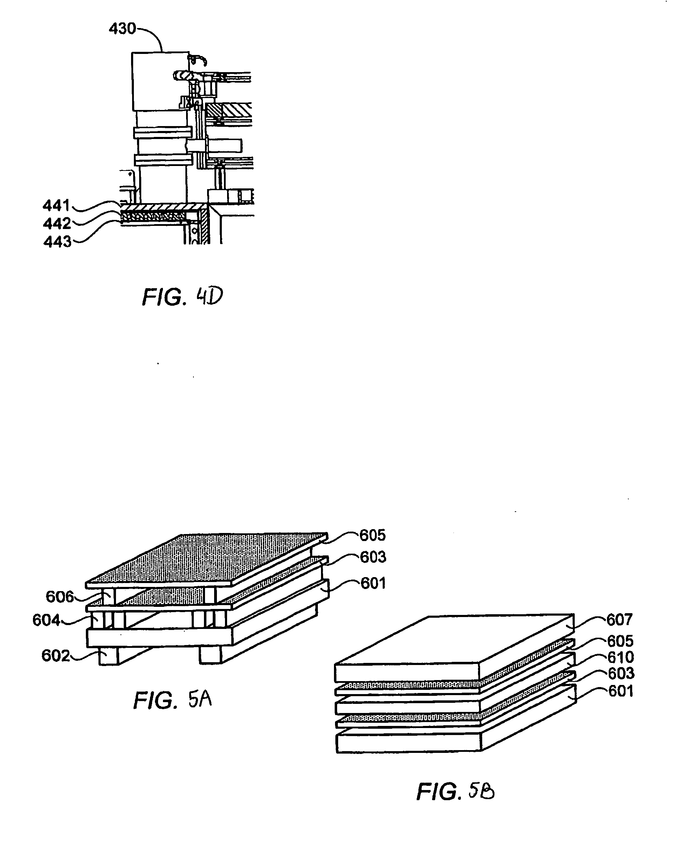

The charged particle lithography system is located in a vacuum chamber. All of the major elements of the lithography system are housed in a common vacuum chamber, including the charged particle source, projector system for projecting the beamlets onto the wafer, and the moveable wafer stage. FIGS. 4A-4D show an embodiment of a vacuum chamber 400 for housing a charged particle lithography system.

The embodiment shown in FIGS. 4A-4D comprises a vacuum chamber 400 with a door 402 in the back wall of the chamber, and in this example also forming the back wall. The embodiment further comprises a wafer loading slot 418 in the front wall of the chamber (shown in FIG. 4C), and ports 420 and vacuum pumps 430 on the top wall of the chamber, in this example so-called turbo-pumps. The chamber 400 may be constructed from stainless steel, aluminum, or other suitable materials, or a combination of these materials. Lighter materials such as aluminum are preferred to reduce the weight of the chamber, which is particularly important when it is anticipated the lithography machine will be transported from the factory to fab site by air (which may be preferred to avoid corrosion and other problems caused by sea transport).

Cross beams or girders 404 may be used for reinforcing the wall plates 405, so that a thinner plate thickness may be used for the walls to reduce the weight and cost of the chamber. However, for some walls of the chamber this construction is not preferred, for example for the walls where openings are located. These walls are preferably constructed of thicker plates to provide the required rigidity despite having openings.

The walls of the vacuum chamber preferably also include one or more mu metal layers, to provide isolation from magnetic fields external to the chamber. Such magnetic fields may influence the electron beams and interfere with correct operation of the lithography system. The mu metal may be included on the inside surface of the chamber walls, or sandwiched within the wall construction between layers of other material. Alternatively, the mu metal may be included on the outside surface of the chamber walls. Parts protruding the chamber, such as leg or supports of the lithography machine (wafer stage and charged particle column) and actuator rods for the stage, are covered by a bellows construction of mu metal, i.e. a mu metal construction extending outside the chamber.

FIG. 5A shows an embodiment of a vacuum chamber with two layers of mu metal. A section of the chamber wall 601 is shown with reinforcing beams 602 on the outside surface of the wall, for example reinforcing beams or girders 407 in FIG. 4A. A first mu metal layer 603 has spacing members 604 in the form of ribs between the mu metal layer 603 and chamber wall 601, to create a space between them. A second mu metal layer 605 has spacing members 606 between the two mu metal layers, to create a space between them. The mu metal layers have holes in them to avoid pressure differences in the vacuum chamber when the chamber is evacuated.

FIG. 5B shows an alternative embodiment of a vacuum chamber with an open layer 610 separating the two layers of mu metal 603 and 605, where the layer 610 preferably has an open structure such as a honeycomb. The layers are shown separated in the drawing for clarity, but the layers would be formed into a single composite wall in practice. The layer 610 provides a light-weight but rigid wall separating the two mu metal layers rendering a sandwich construction, so that the spacing members 604 and 606 in the embodiment of FIG. 5A can be dispensed with. This construction may also enable the reinforcing beams 602 on the outside surface of the wall 601 to be eliminated. A second wall 607 may also be provided. The walls 601 and 607 are preferably made from aluminum, and the layer 610 is preferably an aluminum honeycomb. The resulting composite wall structure provides a wall that is easy and cheap to manufacture, can be prefabricated, and is lightweight and rigid, with the honeycomb layer providing the required strength for the wall. Furthermore, the composite wall structure may incorporate one or more layers of mu shielding.

The mu metal layers are preferably separated from conducting layers by an insulating layer, such as a composite layer of carbon fiber and/or glass reinforced plastic. One embodiment of the composite wall comprises a sandwich construction comprising a first insulating layer, an aluminum honeycomb layer, a mu metal layer, a second insulating layer, and a solid aluminum layer. Additional sets of mu metal layers and insulating layers may be added to increase the magnetic field shielding of the chamber wall. The solid aluminum layer is preferably on the vacuum side. The honeycomb aluminum provides the strength of the sandwich. The thickness of the honeycomb layer may be increased, or additional honeycomb layers used to increase the stiffness of the wall. The layers are preferably glued together. When the open layer 610 is made from an insulating material, this can itself provide an insulating layer to separate the mu metal layers. A composite chamber wall using this construction provides a light weight and rigid wall that can be prefabricated, and designed with the required level of magnetic shielding. This structure incorporates the mu metal shielding into the wall of the vacuum chamber, and avoids using thick solid metal layers to obtain the required strength. Note that any of the composite walls described above may be used in any of the embodiment of the vacuum chamber described herein.

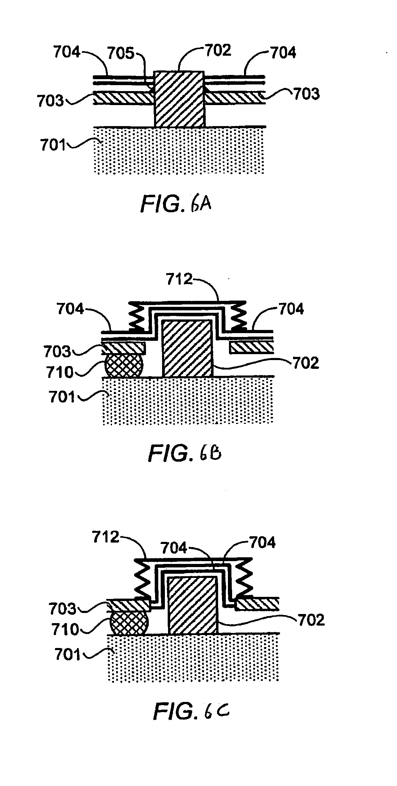

FIG. 6A shows a cross section through the bottom wall (floor) of the vacuum chamber 400 where it interfaces with the frame supporting the lithography machine housed in the chamber. Frame member 702 is shown extending through the chamber wall and resting on base plate 701. Chamber walls 703 abut the frame member 702 and may be welded to the frame member (weld 705). Two mu metal layers 704 also abut the frame member 702 to avoid gaps which can permit external magnetic fields to enter the chamber.

In order to reduce acoustic and vibrational coupling between the base plate 701 and the vacuum chamber 400 which can affect the stability of the lithography machine, alternative embodiments are shown in FIGS. 6B and 6C. In these embodiments, the chamber walls 703 embodiments are shown in FIGS. 6B and 6C. In these embodiments, the chamber walls 703 are not rigidly fixed to frame member 702, and have a small gap between the walls and the frame member. The walls are supported in part by a vibration damping element 710 such as an air mount. The mu metal layers 704 extend over, or, alternatively, underneath, the frame member 702 to eliminate any gaps in the shield. A bellows section 712 may also be provided, extending over the frame member 702, to provide additional support to the chamber wall and providing additional sealing around the frame member while permitting some flexing to reduce mechanical coupling between the base plate and the chamber walls. In the embodiment of FIG. 6B, the bellows section 712 is coupled to the mu metal layers 704. In the embodiment of FIG. 6C, the bellows section 712 is coupled to the chamber walls 703 instead. Additionally, the mu metal layers 704 are coupled to the chamber walls 705, e.g. by clamping.

The lithography machine requires a large number of electrical and optical signals to operate, which must exit the vacuum chamber for connection to control systems which are typically located outside the chamber. The vacuum housing includes openings, referred to as ports, for admitting cables carrying the signals from the control systems into the vacuum housing. The ports are designed to make a vacuum seal around the cables. The lithography system preferably has a modular construction so that various critical subsystems can be removed from the system and replaced without disturbing other subsystems. To facilitate this design, each such modular subsystem preferably has its collection of electrical, optical, and/or power cabling connections routed through one or more ports dedicated to that module. This enables the cables for a particular module to be disconnected, removed, and replaced without disturbing cables for any of the other modules. The ports are preferably designed to facilitate the removal and replacement of the cables, connectors, and port lids as a unit, for example an electronic unit. The vacuum chamber also requires openings for one or more vacuum pumps to pump air from the chamber to evacuate the chamber.

In the embodiment shown in FIGS. 4A-4D, the ports 420 and vacuum pumps 430 are located on the top wall of the chamber 400. In this embodiment, four vacuum pumps 430, e.g. turbo pumps, are provided in cylindrical housings along the front side of the top wall, connected to vacuum pump openings 431, and twenty cylindrical ports 420 are provided arranged on both sides of the top wall. The cabling from the ports is routed to the associated control systems via conduits 437 arranged in cable rack 438.

A vacuum chamber 400 may have one of more dedicated vacuum pumps 430. Also, one or more vacuum pumps may be shared between several vacuum chambers. Each chamber may have a small vacuum pump, and share a larger vacuum pump. The ability to use more than one pump to realize a vacuum in the vacuum chamber 400 creates a vacuum pump redundancy that may improve the reliability of vacuum operation. If a vacuum pump malfunctions, another vacuum pump can take over its function.

Referring back to FIGS. 4A-4D, the door 402 preferably forms the entire back wall [0041] Referring back to FIGS. 4A-4D, the door 402 preferably forms the entire back wall of the chamber 400. Although this arrangement creates several problems, it also provides an important advantage. The large size of the door in this design increases the length of the sealing edge around the door, making it more difficult to maintain a vacuum in the chamber. To achieve a good seal, the door must be very flat and rigid, which is more difficult to achieve due to its large size, and results in a heavier door making it more difficult to open and close. The large size requires more free space around the chamber to accommodate the usual swinging door, using up valuable floor space in the fab. However, a door forming the entire back wall of the chamber provides maximum width and height for moving components of the lithography system into and out of the chamber, which is an important advantage in a lithography system having a modular design. It allows sliding out of a module, and subsequently exchanging it, for example to be serviced, without a need to enter the vacuum chamber.

The door 402 may be constructed from stainless steel, aluminum, or other suitable materials or combination of materials including a sandwiched wall construction, for example as described earlier. The door preferably includes one or more mu metal layers, similarly to the chamber walls, to provide isolation from external magnetic fields. To reduce the weight of the door while maintaining the required rigidity, the door panel 406 preferably includes vertical and/or horizontal reinforcing beams or girders 407. The outer edge of the door may also be reinforced, for example by a strip-like reinforcement member attached to the outside or inside perimeter of the door.

The door preferably opens upwards, substantially vertically, to minimize the floor space required for the lithography machine. This arrangement permits other equipment or a wall to be located in relatively close proximity to back side of the lithography machine, or avoids having the door block required working or access space.

In some embodiments the door is mounted on hinged arms to enable the door to swing upwards. The embodiment in FIGS. 4A-4D uses this design. This embodiment employs two arms 410 on each side of the door in a parallelogram arrangement. The arms 410 are rotatably attached to the door 402 via rods 414. The arms 410 permit the door 402 to move in an arc, with the arms extending downwards from a hinging point 411 when the door is in the closed position, and extending upwards when the door is in the open position.

An actuation member 412, such as an electric screw spindle, may be provided to assist with opening and closing the door 402, to counteract in part the weight of the door. The actuation member 412 extends obliquely upwardly with its lower end near the door and its higher end connecting to one of the arms 410 further from the door and near the pivot point 411 of the arm. Alternative means may also be provided for this purpose, e.g. counterweights or springs. The weight of the door 402, combined with the geometry of the arms 410, pushes the door against the chamber walls when in the closed position. As shown in FIG. 4A, the arms 410 are relatively long and assume a relatively steep angle to the vertical when the door is closed, so that a large closing force is provided by the weight of the door 402 and the force of gravity. This closing force is preferably sufficient to achieve the initial sealing required to develop a vacuum in the chamber.

The outer edge of the door 402 forms a seal against the walls of the vacuum chamber 400. For this purpose, a flat strip may be attached to the upper, lower and side walls of the chamber to mate with a corresponding flat area around the perimeter of the door. An O-ring, and preferably two O-rings arranged as an inner and outer O-ring, are provided on the surface of the flat strip or the door perimeter.

In order to provide satisfactory sealing so that the required vacuum can be maintained in the vacuum chamber, the door should be substantially flat so that it fits against the walls of the chamber without gaps. The door preferably fits against the chamber with a maximum play of about 0.1 mm, to allow the vacuum pumping system to create sufficient vacuum pressure in the chamber so that the door is pressed against the O-rings by the ambient pressure outside the chamber to allow full vacuum pressure to be achieved. The required flatness of the door can be achieved by flattening the outer edges of the door after it has been constructed, e.g. by milling.

The closing force due to the weight of the door and the geometry of the arms is preferably sufficient to achieve the initial sealing without requiring additional force to be applied to the door. If the initial sealing is achieved, operation of the vacuum pumping system will pull the door against the O-rings and full vacuum pressure in the chamber can be achieved. Locking lugs or bolts 416 can also be used to ensure the door 402 is sealed against the chamber walls.

A panel 417 is located in the front wall of the vacuum chamber 400, including a slot 418 for receiving wafers from a wafer load system. Additional openings 419 are also included for actuator rods to enter the vacuum chamber from a stage actuator outside the chamber. The stage actuator moves the stage inside the chamber to enable scanning of the wafer by the lithography machine. The stage actuator typically uses electric motors to produce the required mechanical movement of the stage, and these electric motors generate electromagnetic fields which can disturb the charged particle beams used by the lithography machine. To avoid this disturbance, the stage actuator is located outside the mu metal shield of the chamber. Rods from the stage actuator enter the vacuum chamber through holes 419 in the chamber wall to move the stage inside the chamber. The front wall of the vacuum chamber is preferably constructed of thicker solid plate to accommodate the openings.

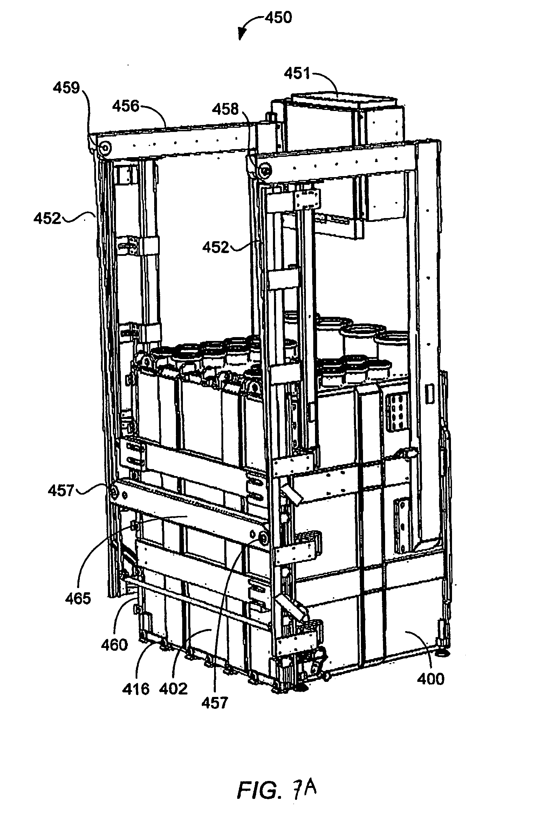

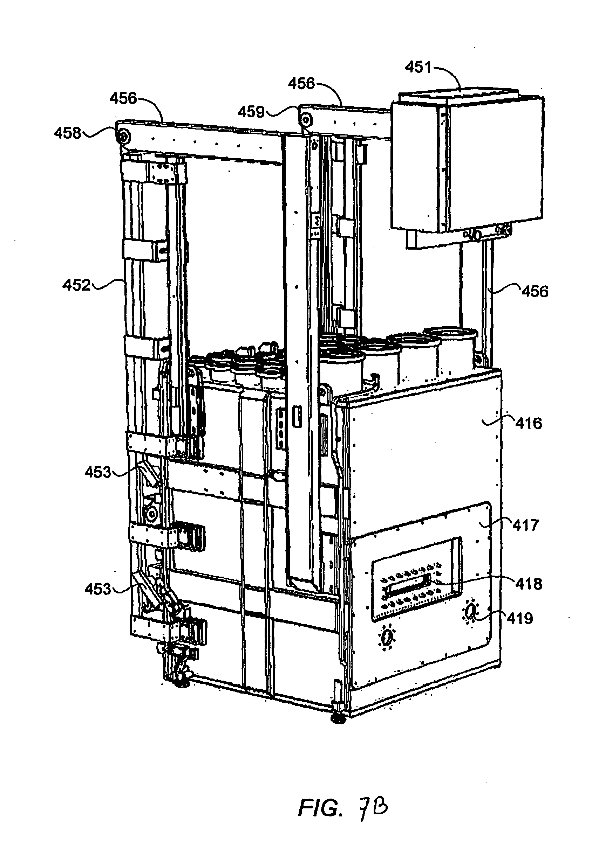

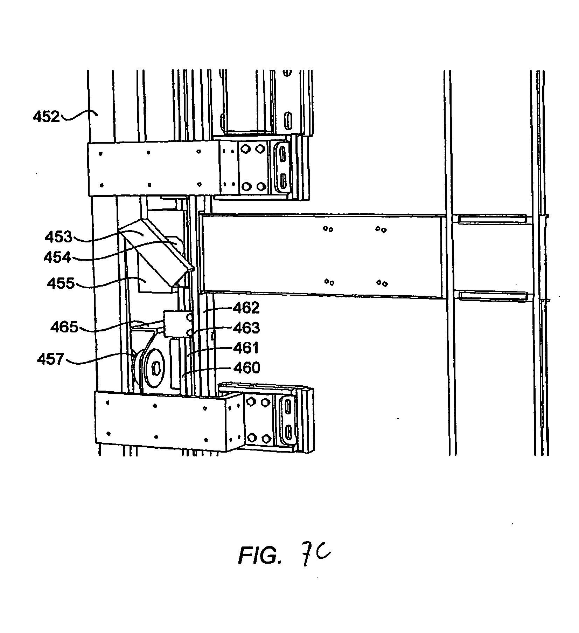

In some embodiments of the vacuum chamber, the door is opened by a lift system, the door being guided on each side of the door as it lifts. One such embodiment shown in FIGS. 7A-7C, has a lift system 450 comprising an electric hoist 451 for lifting the door 402 FIGS. 7A-7C, has a lift system 450 comprising an electric hoist 451 for lifting the door 402 using a chain on each side of the door. A suitable hoist for this embodiment is, for example, Demag hoist model DCS-Pro 5-500. A winch may also be used with cables, wires, ropes, or other flexible lift elements or other inflexible lift elements such as a gear rack. However, a chain is preferred for low elasticity, due to its suitability for clean room environments, due to the constant angle and position of the chain leaving and entering the hoist (in contrast to a cable changing angle and position as it is wound onto the drum of a winch), and due to its flexibility in all directions.

The lift system 450 is provided with guiding elements for guiding the door at least in a first stage of opening in both vertical and horizontal directions. Door guides 452, supported by a frame 456, are provided on each side of the door in the form of guide rails running substantially vertically, with an inclined portion 453 at the lower ends bringing the guide rails towards the door 402 at an angle of about 45 degrees. Guide pins or rollers 454 (preferably with protrude from each side of the door for engagement with the guide rails 452, the guide pins sliding along the trough formed by the guide rails as the door opens and closes. The guide pins 454 may be connected directly to the door panel or preferably to door reinforcing beams 455. When the door 402 is being opened, the configuration of the door guides 452 results in the door initially moving upwards and outwards (at an angle of 45 degrees in this embodiment), followed by a vertical or almost vertical movement until the door is raised completely above the top wall of the vacuum chamber to provide unhindered access to the chamber interior.

When the door 402 is being closed, the door initially moves vertically or almost vertically and then closes against the chamber moving downwards and inwards at an angle. As for the previous embodiment, the door preferably fits against the chamber with a maximum play of about 0.1 mm. The closing force due to the weight of the door and the geometry of the door guides is preferably sufficient to achieve the initial sealing without requiring additional force to be applied to the door. If the initial sealing is achieved, operation of the vacuum pumping system will pull the door against the O-rings and full vacuum pressure in the chamber can be achieved. Lesser initial sealing may to some extent be compensated though by using high capacity pumps in a shared configuration. Locking lugs or bolts 416 can also be used to ensure the door 402 is sealed against the chamber walls.

The outer edge of the door 402 may also be reinforced, for example by a strip-like reinforcement member 460 attached to the outside or inside perimeter 461 of the door. The outer edge of the door forms a seal against the walls of the vacuum chamber. A flat strip 463 may be attached to the upper, lower and side walls of the chamber to mate with a corresponding flat area 461 around the perimeter of the door. An O-ring, and preferably two O-rings arranged as an inner and outer O-ring, are provided on the surface of the flat strip 463 or the door perimeter 461.

Guiding elements 457 are also provided to guide the chain as the door 402 is opened and closed. In the embodiment of FIGS. 7A-7C, a chain-gutter is provided alongside the door guides 452. The chain is attached at one end to the frame on one side of the chamber at point 458. The chain runs down the right side door guide 452, around a right chain guiding element 457, across the outer side of the door 402 in channel 465, around a left chain guiding element 457, up the left side door guide 452, around a third chain guiding element (459) at the upper end of the frame 452, and across to the hoist 451. This arrangement reduces required lifting force by half while using only one hoist.

The chain guides 457 are preferably located lower on the door 402, below or connected to a door reinforcing beam, and are preferably constructed as a roller, wheel, or other element able to guide the chain while transmitting the lifting force to the door.

Although a chain system is used for this embodiment, other lift elements may be used, either attached directly to the door or transmitting lifting force via guiding blocks or rollers attached to the door. A pneumatic or hydraulic lift system may also used, lifting the door via flexible lift elements or rigid arms or struts.

The hoist or winch motor or actuator is preferably located above the chamber, supported by frame 456. This makes efficient use of the fab floor space, as the lifting equipment then uses vertical space that is required to accommodate the opening height of the door. The winch or crane may be self locking, or provided with a locking device for safety purposes. Equipment racks may also be conveniently located above the vacuum chamber, also supported by the frame 456. These racks are preferably used to house high voltage control circuitry and beam switching and beam scan deflection circuitry, which is preferably located in close proximity to the lithography machine in the vacuum chamber. This makes efficient use of the fab floor space.

The invention has been described by reference to certain embodiments discussed above. It should be noted various constructions and alternatives have been described, which may be used with any of the embodiments described herein, as would be know by those of skill in the art. Furthermore, it will be recognized that these embodiments are susceptible to various modifications and alternative forms well known to those of skill in the art without departing from the scope of the invention. Accordingly, although specific embodiments have been described, these are examples only and are not limiting upon the scope of the invention, which is defined in the accompanying claims.

## Claims

1. A charged particle lithography apparatus (100) comprising:
a charged particle source (101) for creating one or more charged particle beams (123);
a charged particle projector (108, 109, 110) for projecting the beams onto a wafer; and
a moveable wafer stage (132) for carrying the wafer (130);
**characterised by**
a common vacuum chamber (140, 400) for forming a vacuum environment, the common vacuum chamber comprising:
a door (402) permitting access to the apparatus for maintenance, repair, and operational adjustment; and
an opening (418) for loading wafers into the common vacuum chamber,
wherein the charged particle source, charged particle projector, and moveable wafer stage are disposed in the common vacuum chamber.

2. The apparatus of claim 1, wherein the door (402) forms one entire wall of the common vacuum chamber (400).

3. The apparatus of any one of the preceding claims, wherein the walls of the common vacuum chamber (400) comprise a composite structure including one or more layers of mu metal (603, 605).

4. The apparatus of any one of the preceding claims, wherein the walls of the common vacuum chamber (400) comprise a composite structure including a layer of aluminum (601, 607) and a layer of mu metal (603, 605), the layer of aluminum being separated from the layer ofmu metal by a plurality of spacing members (604, 606).

5. The apparatus of claim 4, wherein the composite structure further includes a further layer of mu metal (605), separated from the layer of mu metal (603) by a plurality of further spacing members (606).

6. The apparatus of claim 5, further comprising one or more electrically insulating layers for insulating the mu metal layers (603, 605).

7. The apparatus of any one of the preceding claims, wherein parts protruding into the common vacuum chamber (400) are covered by a bellows structure (712) comprised of or covering one or more layers of mu metal (704).

8. The apparatus of any one of the preceding claims, wherein the common vacuum chamber (400) is provided with a lift system (450) for opening the door (402) by lifting the door in a vertical direction or a predominantly vertical direction.

9. The apparatus of claim 8, wherein the lift system (450) is provided with guiding elements (452, 453) for guiding the door (402) at least in a first stage of opening in both a vertical and a horizontal direction.

10. The apparatus of any one of the preceding claims, wherein the common vacuum chamber is provided with at least one arm (410) on each side of the door (402) for opening the door in a predominantly vertical direction, the arms extending downwards from a hinging point (411) to connect to the door.

11. The apparatus of any one of the preceding claims, wherein the source (101; 152) is situated in a source chamber (150).

12. The apparatus of any one of the preceding claims, wherein one or more subsystems of the apparatus are constructed in self-contained and removable modules, the removable modules comprising one or more of:
an illumination optics module (201) including the charged particle source (101) and beam collimating system (102);
an aperture array and condenser lens module (202) including an aperture array (103) and condenser lens array (104);
a beam switching module (203) including a beamlet blanker array (105); and
a projection optics module (204) including the charged particle projector, the charged particle projector comprising a beam stop array (108), beam deflector array (109), and one or more projection lens arrays (110),
wherein the door permits moving the self-contained and removable modules into and out of the common chamber.

13. The apparatus of claim 12, wherein the movable wafer stage comprises a wafer table (209) for supporting a wafer (130), a chuck (210) for holding the wafer table, a short stroke stage element (211), and a long stroke stage element (212).

14. The apparatus of any one of the preceding claims, wherein the common chamber (400) is provided with ports (420) for admitting electrical, optical, and/or power cables or wires into the common chamber (400), the ports providing a seal around the cables or wires.

15. An arrangement comprising a charged particle lithography apparatus according to any one of the preceding lithography apparatus claims and a frame (701, 702) for supporting the common vacuum chamber (400) of the charged particle lithography apparatus, wherein the common vacuum chamber (400) and the frame (701, 702) are coupled to each other via a vibration damping element (710).

## Patentansprüche

1. Geladene-Teilchen Lithographie-Vorrichtung (100), umfassend:
eine Quelle für geladene Teilchen (101) zur Erzeugung von einem oder
mehreren Strahlen aus geladenen Teilchen (123);
einen Projektor für geladene Teilchen (108, 109, 110) zum Projizieren der Strahlen auf einen Wafer;
**gekennzeichnet durch** einen beweglichen Wafertisch (132) zum Tragen des Wafers (130);
eine gemeinsame Vakuumkammer (140, 400) zur Bildung einer Vakuumumgebung, wobei die gemeinsame Vakuumkammer umfasst:
eine Tür (402), die Zugang zu der Vorrichtung zwecks Wartung, Reparatur und Betriebsjustierung ermöglicht; und
eine Öffnung (418) zum Laden von Wafern in die gemeinsame Vakuumkammer;
wobei sich die Quelle für geladene Teilchen, der Projektor für geladene Teilchen und der bewegliche Wafertisch in der gemeinsamen Vakuumkammer befinden.

2. Vorrichtung gemäß Anspruch 1, wobei die Tür (402) eine ganze Wand der gemeinsamen Vakuumkammer (400) bildet.

3. Vorrichtung gemäß einem der vorstehenden Ansprüche, wobei die Wände der gemeinsamen Vakuumkammer (400) eine Verbundstruktur umfassen, die eine oder mehrere Schichten aus Mu-Metall (603, 605) beinhaltet.

4. Vorrichtung gemäß einem der vorstehenden Ansprüche, wobei die Wände der gemeinsamen Vakuumkammer (400) eine Verbundstruktur umfassen, die eine Schicht aus Aluminium (601, 607) und eine Schicht aus Mu-Metall (603, 605) beinhaltet, wobei die Schicht aus Aluminium durch eine Vielzahl von Abstandshaltern (604, 606) von der Schicht aus Mu-Metall getrennt ist.

5. Vorrichtung gemäß Anspruch 4, wobei die Verbundstruktur weiterhin eine weitere Schicht aus Mu-Metall (605) umfasst, die durch eine Vielzahl von weiteren Abstandshaltern (606) von der Schicht aus Mu-Metall (603) getrennt ist.

6. Vorrichtung gemäß Anspruch 5, die weiterhin eine oder mehrere elektrisch isolierende Schichten zur Isolierung der Mu-Metall-Schichten (603, 605) umfasst.

7. Vorrichtung gemäß einem der vorstehenden Ansprüche, wobei Teile, die in die gemeinsame Vakuumkammer (400) hineinragen, durch eine Faltenbalgstruktur (712), die aus einer oder mehreren Schichten aus Mu-Metall (704) besteht oder diese abdeckt, abgedeckt sind.

8. Vorrichtung gemäß einem der vorstehenden Ansprüche, wobei die gemeinsame Vakuumkammer (400) mit einem Hubsystem (450) versehen ist, um die Tür (402) zu öffnen, indem die Tür in eine vertikale Richtung oder eine vorwiegend vertikale Richtung angehoben wird.

9. Vorrichtung gemäß Anspruch 8, wobei das Hubsystem (450) mit Führungselementen (452, 453) versehen ist, um die Tür (402) wenigstens in einem ersten Stadium der Öffnung sowohl in einer vertikalen als auch in einer horizontalen Richtung zu führen.

10. Vorrichtung gemäß einem der vorstehenden Ansprüche, wobei die gemeinsame Vakuumkammer mit wenigstens einem Arm (410) auf jeder Seite der Tür (402) versehen ist, um die Tür in einer vorwiegend vertikalen Richtung zu öffnen, wobei sich die Arme ausgehend von einem Scharnierpunkt (411), an dem sie mit der Tür verbunden sind, nach unten erstrecken.

11. Vorrichtung gemäß einem der vorstehenden Ansprüche, wobei sich die Quelle (101; 152) in einer Quellenkammer (150) befindet.

12. Vorrichtung gemäß einem der vorstehenden Ansprüche, wobei ein oder mehrere Subsysteme der Vorrichtung als eigenständige und entnehmbare Module konstruiert sind, wobei die entnehmbaren Module eines oder mehrere der Folgenden umfassen:
ein Beleuchtungsoptikmodul (201), das die Quelle für geladene Teilchen (101) und ein Strahlenkollimationssystem (102) beinhaltet;
ein Blendenanordnungs- und Kondensor-Modul (202), das eine Blendenanordnung (103) und eine Kondensoranordnung (104) beinhaltet;
ein Strahlenumschaltmodul (203), das eine Strahlenausblenderanordnung (105) beinhaltet; und
ein Projektionsoptikmodul (204), das den Projektor für geladene Teilchen beinhaltet, wobei der Projektor für geladene Teilchen eine Strahlfängeranordnung (108), eine Strahldeflektoranordnung (109) und eine oder mehrere Projektionslinsenanordnungen (110) umfasst;
wobei die Tür das Bewegen der eigenständigen und entnehmbaren Module in die gemeinsame Vakuumkammer und aus der gemeinsamen Vakuumkammer heraus ermöglicht.

13. Vorrichtung gemäß Anspruch 12, wobei der bewegliche Wafertisch einen Waferteller (209) zur Unterstützung eines Wafers (130), ein Spannfutter (210) zum Halten des Wafertellers, ein kurzhubiges Tischelement (211) und ein langhubiges Tischelement (212) umfasst.

14. Vorrichtung gemäß einem der vorstehenden Ansprüche, wobei die gemeinsame Vakuumkammer (400) mit Anschlüssen (420) versehen ist, um elektrische, optische und/oder Stromkabel oder -drähte in die gemeinsame Vakuumkammer (400) einzulassen, wobei die Anschlüsse für eine Abdichtung um die Kabel oder Drähte herum sorgen.

15. Anordnung, umfassend eine Teilchenstrahllithographie-Vorrichtung gemäß einem der vorstehenden Lithographievorrichtungsansprüche und ein Gestell (701, 702) zur Unterstützung der gemeinsamen Vakuumkammer (400) der Teilchenstrahllithographie-Vorrichtung, wobei die gemeinsame Vakuumkammer (400) und das Gerüst (701, 702) über ein Schwingungsdämpfungselement (710) miteinander gekoppelt sind.

## Revendications

1. Appareil de lithographie à particules chargées (100) comprenant :
une source de particules chargées (101) pour créer un ou plusieurs faisceaux de particules chargées (123) ;
un projecteur de particules chargées (108, 109, 110) pour projeter les faisceaux sur une plaquette ; et
une platine de plaquette mobile (132) pour supporter la plaquette (130) ;
**caractérisé par**
une chambre à vide commune (140, 400) pour former un environnement sous vide, la chambre à vide commune comprenant :
une porte (402) permettant un accès à l'appareil pour l'entretien, la réparation et le réglage de fonctionnement ; et
une ouverture (418) pour charger des plaquettes dans la chambre à vide commune,
dans lequel la source de particules chargées, le projecteur de particules chargées et la platine de plaquette mobile sont disposés dans la chambre à vide commune.

2. Appareil selon la revendication 1, dans lequel la porte (402) forme une paroi complète de la chambre à vide commune (400).

3. Appareil selon l'une quelconque des revendications précédentes, dans lequel les parois de la chambre à vide commune (400) comprennent une structure composite comportant une ou plusieurs couches de métal mu (603, 605).

4. Appareil selon l'une quelconque des revendications précédentes, dans lequel les parois de la chambre à vide commune (400) comprennent une structure composite comportant une couche d'aluminium (601, 607) et une couche de métal mu (603, 605), la couche d'aluminium étant séparée de la couche de métal mu par une pluralité d'éléments d'espacement (604, 606).

5. Appareil selon la revendication 4, dans lequel la structure composite comprend en outre une autre couche de métal mu (605), séparée de la couche de métal mu (603) par une pluralité d'autres éléments d'espacement (606).

6. Appareil selon la revendication 5, comprenant en outre une ou plusieurs couches électriquement isolantes pour isoler les couches de métal mu (603, 605).

7. Appareil selon l'une quelconque des revendications précédentes, dans lequel des parties en saillie dans la chambre à vide commune (400) sont couvertes par une structure à soufflet (712) constituée par ou recouvrant une ou plusieurs couches de métal mu (704).

8. Appareil selon l'une quelconque des revendications précédentes, dans lequel la chambre à vide commune (400) est dotée d'un système de levage (450) pour ouvrir la porte (402) en levant la porte dans une direction verticale ou une direction principalement verticale.

9. Appareil selon la revendication 8, dans lequel le système de levage (450) est doté d'éléments de guidage (452, 453) pour guider la porte (402) au moins dans une première phase d'ouverture à la fois dans une direction verticale et une direction horizontale.

10. Appareil selon l'une quelconque des revendications précédentes, dans lequel la chambre à vide commune est dotée d'au moins un bras (410) sur chaque côté de la porte (402) pour ouvrir la porte dans une direction principalement verticale, les bras s'étendant vers le bas à partir d'un point d'articulation (411) pour se connecter à la porte.

11. Appareil selon l'une quelconque des revendications précédentes, dans lequel la source (101 ; 152) est située dans une chambre de source (150).

12. Appareil selon l'une quelconque des revendications précédentes, dans lequel un ou plusieurs sous-systèmes de l'appareil sont construits en modules autonomes et amovibles, les modules amovibles comprenant un ou plusieurs parmi :
un module d'optique d'illumination (201) comprenant la source de particules chargées (101) et un système de collimation de faisceau (102) ;
un module de lentille de condenseur et réseau d'ouvertures (202) comprenant un réseau d'ouvertures (103) et un réseau de lentilles de condenseur (104) ;
un module de commutation de faisceau (203) comprenant un réseau de dispositifs d'occultation de faisceau (105) ; et
un module d'optique de projection (204) comprenant le projecteur de particules chargées, le projecteur de particules chargées comprenant un réseau de dispositifs d'arrêt de faisceau (108), un réseau de déflecteurs de faisceau (109) et un ou plusieurs réseaux de lentilles de projection (110),
dans lequel la porte permet de déplacer les modules autonomes et amovibles dans et hors de la chambre à vide commune.

13. Appareil selon la revendication 12, dans lequel la platine de plaquette mobile comprend une table pour plaquette (209) pour supporter une plaquette (130), un mandrin (210) pour maintenir la table pour plaquette, un élément de platine à course courte (211) et un élément de platine à course longue (212).

14. Appareil selon l'une quelconque des revendications précédentes, dans lequel la chambre à vide commune (400) est dotée d'orifices (420) pour recevoir des câbles ou fils électriques, optiques et/ou d'alimentation dans la chambre à vide commune (400), les orifices fournissant une étanchéité autour des câbles ou fils.

15. Agencement comprenant un appareil de lithographie à particules chargées selon l'une quelconque des revendications précédentes d'appareil de lithographie et un châssis (701, 702) pour supporter la chambre à vide commune (400) de l'appareil de lithographie à particules chargées, dans lequel la chambre à vide commune (400) et le châssis (701, 702) sont couplés entre eux par le biais d'un élément amortisseur de vibrations (710).
